# EUROPEAN PATENT APPLICATION

(11) **EP 4 468 368 A1**
(43) Date of publication of application: **27.11.2024**
(21) Application number: 23175166.0
(22) Date of filing: 24.05.2023
(51) Int. Cl.: H01L 29/78, H01L 29/417, H01L 29/423, H01L 21/336

(54) **SEMICONDUCTOR DEVICE WITH ENHANCED DRAIN**

(71) Applicant: Nexperia B.V., 6534 AB Nijmegen (NL)
(72) Inventor: Hung, Shih-Hsuan, Hamburg (DE); Ong, Kilian, Hamburg (DE)
(74) Representative: Pjanovic, Ilija

(57) **Abstract**

A semiconductor device with an enhanced drain and its method of manufacture are disclosed. The semiconductor device has a substrate with a die portion surrounded by a peripheral portion. A gate region is formed on the die portion, a source region is formed in a first doped region of the die portion and a first drain region is formed in a second doped region of the die portion. Each region is connected to at least one respective terminal formed on the surface of the substrate, and a second drain region is formed in a doped region of the peripheral portion, with a peripheral member electrically connected to each drain region terminal, wherein the first and second drain regions lead out from a back surface of the substrate.

## Description

### FIELD OF INVENTION

The present invention relates to a semiconductor device. The invention also relates to a method of manufacturing a semiconductor device.

### BACKGROUND TO INVENTION

In semiconductor devices, particularly Metal Oxide Semiconductor Field Effect Transistor (`MOSFET') devices, the resistance between drain and source terminals of the device when it is in the "on" state has a significant impact on the power efficiency of the circuit. This resistance, known as the device's on-resistance and abbreviated Rds(on), is inherent to the MOSFET channel and is expressed as Rds(on) = ρ × UW, wherein ρ is the resistivity of the semiconductor material, L is the length of the channel, and W is the width of the channel.

Logically, the lower the RDS(on) value of the MOSFET device, the more efficient it is, so that it may handle ever higher currents with ever less power dissipation. Many techniques have accordingly been developed for reducing the length and width of a MOSFET channel, in order to reduce resistance to the flow of current. In that context, certain MOSFETs have been configured with a trench structure, that provides an equal or larger surface area for a channel of reduced length and width, and which advantageously reduces the on-resistance further.

Chip Scale Packaging ('CSP') techniques typically implant solder balls on a MOSFET surface instead of bonding metal leads, for reducing parasitic inductance and parasitic resistance associated with the traditional leads. CPS techniques allow smaller package sizes and simpler packaging processes, but require accessibility to the back of the MOSFET device.

There is an ongoing requirement to reduce semiconductor device size and, in the specific case of MOSFETs, to reduce their channel size but, in that context, preserving access to the back of the device is a conflicting requirement, which hinders improvements to CSP techniques.

### SUMMARY OF INVENTION

Aspects of the invention are set out in the accompanying claims, respectively aimed at various embodiments of a semiconductor device, a chip size package (CSP) device comprising the semiconductor device and a method of manufacturing the semiconductor device.

An aim of the present invention is to facilitate semiconductor size reduction, by structuring the semiconductor device with a peripheral contact area configured as a drain region, which maximises the usability of the device's main die, yet facilitates access to the back of the device.

Accordingly, in a first aspect, a semiconductor device is provided, which comprises a semiconductor substrate comprising a die portion surrounded by a peripheral portion, a gate region formed on the die portion and connected to at least one gate terminal, a source region formed in a first doped region of the die portion and connected to at least one source terminal, a first drain region formed in a second doped region of the die portion and connected to at least one drain terminal, and a second drain region formed in a doped region of the peripheral portion, comprising a peripheral member electrically connected to the or each drain terminal, wherein the or each source terminal, gate terminal and drain terminal is formed on the surface of the semiconductor substrate and wherein the first and second drain regions lead out from a back surface of the substrate.

The peripheral portion with its peripheral member electrically connected to the or each drain terminal maximises the current distribution in the semiconductor device and accordingly provides a device with a contact area associated with the drain region that is fully accessible from a topside of the device, thus readily useable as a CSP device.

In certain embodiments of the semiconductor device, the peripheral portion is located in a dicing lane of a wafer comprising the semiconductor device. In variants of such embodiments, a dimension of the peripheral portion corresponds to a portion of the dicing lane width.

Relative to conventional techniques that maintain the drain implant integrally within the main die portion, the peripheral portion in the dicing lane constitutes an additional drain implant area which sustains the active area size of the semiconductor device and reduces the spreading resistance, and thus lowers the device's on-resistance further.

In certain embodiments of the semiconductor device, a first portion of the second drain region may be contiguous with a portion of the first drain region. In variants of such embodiments, a second portion of the second drain region may be contiguous with a portion of the gate region. In certain embodiments of such variants, the source region may be surrounded by the gate region.

In certain embodiments of the semiconductor device, the peripheral portion may be doped with a higher level of ion implantation relative to the die portion. In variants of such embodiments, the second drain region may be doped with a higher level of ion implantation relative to the first drain region.

Trench MOSFETs are considered to be particularly suitable for embodying the principles disclosed herein, wherein a reduction in channel size can leverage the additional drain area provided by the second drain region for achieving further miniaturisation whilst maintaining access to the back of the device. Accordingly, in certain embodiments of the semiconductor device, the main die portion may be configured with one or more vertical active areas. In variants of such embodiments, the peripheral contact portion may be configured with a vertical active area to access the back of the device.

In certain embodiments of the semiconductor device, the peripheral member may be a metallic runner member. Metallic materials suitable for implementing the runner member include for instance copper and aluminium.

In another aspect, a Chip Size Package (`CSP') device is provided, which comprises at least one semiconductor device embodying the principles disclosed herein and introduced hereinabove.

In a further aspect, a method of manufacturing a semiconductor device is provided, comprising the steps of depositing a semiconductor material on a wafer, generating a pattern of semiconductor devices and dicing lanes with a photolithography process, wherein a mask of the photolithography process is configured to avoid masking portions of dicing lanes, such that each semiconductor device in the pattern comprises a die portion surrounded by a peripheral portion located in the dicing lane portion ; etching excess semiconductor material from the pattern, wherein the step of etching maintains semiconductor material in the form of a unitary member within each peripheral portion ; and doping each peripheral portion and at least a portion of each die portion.

The advantages associated with the peripheral drain region and runner in the semiconductor device disclosed herein can thus be obtained with only minor modifications to conventional semiconductor manufacturing techniques.

In certain embodiments of the method, each peripheral portion may be doped differently from each die portion. In particular, peripheral portions may be doped with a higher level of ion implantation relative to die portions.

Other aspects of the invention are set out in the accompanying claims.

### BRIEF DESCRIPTION OF DRAWINGS

The invention will be more clearly understood from the following description of an embodiment thereof, given by way of example only, with reference to the accompanying drawings, in which: -
Figure 1 is a simplified top view of a wafer substrate with a plurality of semiconductor devices, each with a die portion surrounded by a peripheral portion.
Figure 2 is a simplified top view of a detail of the wafer of Figure 1, showing dicing lanes surrounding semiconductor device dies.
Figure 3 is a schematic top view of an embodiment of a semiconductor device as shown in Figures 1 and 2, comprising drain, source and gate regions, each connected to a respective terminal.
Figure 4 is a schematic view of another embodiment of a semiconductor device as shown in Figures 1 and 2, comprising gate and drain regions, each connected to a respective terminal, and a source region connected to a plurality of terminals.
Figure 5 is a schematic cross-section of a detail of the drain region shown in Figure 3 or 4.
Figure 6 is a schematic cross-section of a detail of the source region shown in Figure 3 or 4.
Figure 7 is a schematic cross-section of a detail of the gate region shown in Figure 3 or 4.
Figure 8 is a schematic view of a further embodiment of a semiconductor device as shown in Figures 1 and 2, comprising gate and drain regions, each connected to a respective terminal, and a source region connected to a plurality of terminals.
Figure 9 is a schematic cross-section of a detail of the gate region shown in Figure 8.

### DETAILED DESCRIPTION OF DRAWINGS

There will now be described by way of example specific modes contemplated by the inventors. In the following description and accompanying figures, numerous specific details are set forth in order to provide a thorough understanding, wherein like reference numerals designate like features. It will be readily apparent to one skilled in the art, that the present invention may be practiced without limitation to these specific details. In other instances, well known methods and structures have not been described in detail, to avoid obscuring the description unnecessarily.

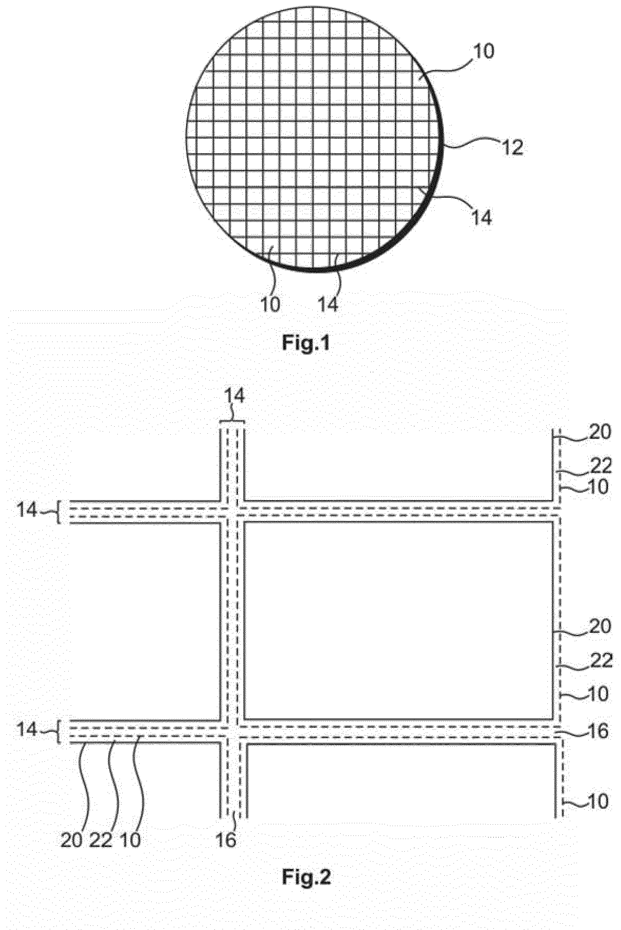

With reference to Figures 1 and 2, wherein like numerals correspond to like features, techniques described herein involve the manufacturing of semiconductor devices 10 on a substrate 12, known in the art as a wafer, which is flat-sliced from an ingot of high-purity, single-crystalline silicon, typically cylindrical in shape. Each wafer 12 is initially cleaned using various chemical processes to remove impurities and contaminants, then undergoes a series of processing steps to create the semiconductor devices 10 thereon.

A semiconductor material is deposited onto the wafer's topside using known techniques, for example chemical vapor deposition (CVD) or physical vapor deposition (PVD). Then, in a photolithography process, a layer of light-sensitive photoresist is deposited onto the top surface of the wafer and exposed to ultraviolet light through an optical mask, for transferring a geometric pattern from the mask onto the photoresist. This pattern is typically a matrix of semiconductor devices 10 delimited by interstitial dicing lanes 14, also known in the art as saw lanes or scribe lines, depending upon the dicing technique employed. Conventionally, each dicing lane is a narrow strip of the underlying substrate material that surrounds the active area of the semiconductor device, created during the photolithography step of the manufacturing process as a border feature in the photomask, to define the boundaries of the device's active area, namely the region of the device wherein the electrical current flows.

According to the present technique, the mask is configured to avoid masking portions of dicing lanes, in such manner that each semiconductor device 10 will comprise a main die portion 20, shown with a solid line in Figures 1 and 2, surrounded by a peripheral portion 22, shown with a dotted line in Figure 2, wherein the peripheral portion is located within a portion of the width of each dicing lane 14 adjacent a respective side of a main die portion 20. As semiconductor devices 10 of the example are substantially rectangular, accordingly each of the main die portion 20 and the peripheral portion 22 is rectangular, wherein adjacent peripheral portions 22 of adjacent semiconductor devices 10 located in a same dicing lane 14 are separated by an interstitial space 16 of semiconductor material that is lost to the dicing process.

The patterned wafer 12 is then etched for removing excess semiconductor material, leaving behind the targeted pattern. Conventionally, this etching step removes semiconductor material in the dicing lanes. According to the present technique however, the etching step is configured to maintain semiconductor material in the form of a unitary member, described in further details hereafter, within the peripheral portion 22 of each semiconductor device 10 on the wafer.

The etched wafer 12, including each peripheral portion 22 in each dicing lane 14 thereof, is then doped with impurities, such as boron or phosphorus, to create desired electrical properties. The wafer 12 is annealed next, to activate the dopants and repair any damage caused by earlier steps.

Electrical contacts or terminals, described in further details hereafter, are then formed on the topside, or top surface, of the wafer 12 to allow for electrical connections between the semiconductor devices and external circuits. At least some of these steps may repeated in order to create complex integrated circuits required by in modern electronic devices, until such time as semiconductor devices 10 can be individually cut from the wafer 10 along the dicing lanes 14.

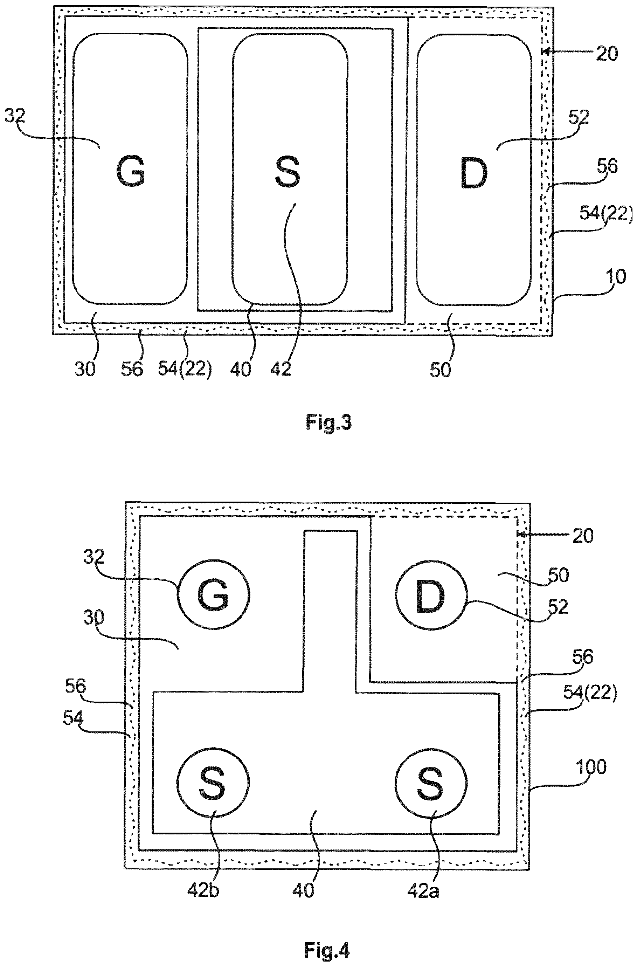

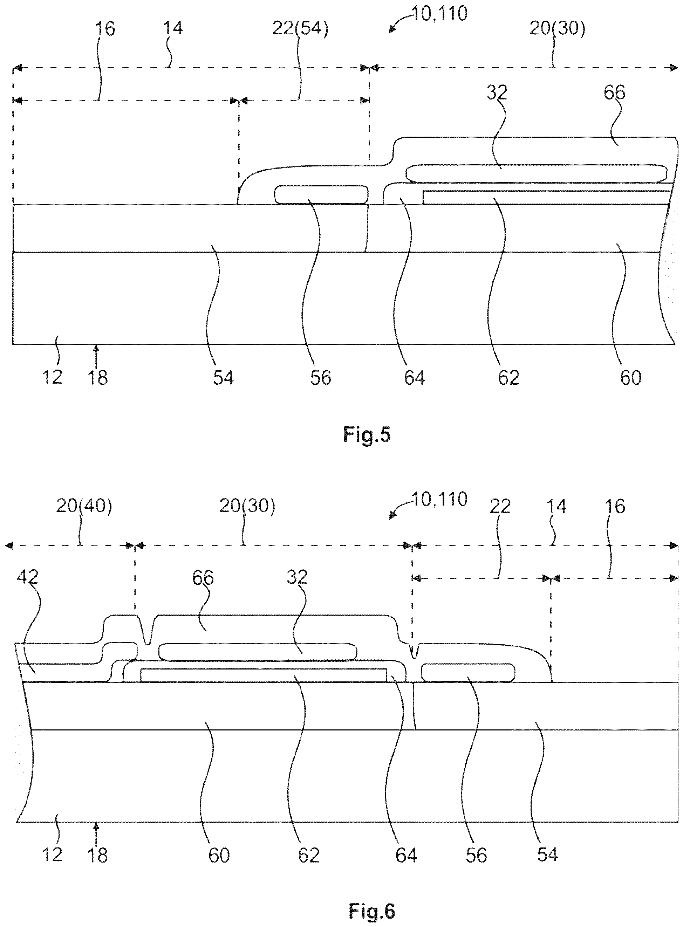

With reference to Figures 3 to 7 next, wherein like numerals correspond to like features, embodiments of a semiconductor device are shown both in top view in Figures 3 and 4 and in several cross-sectional views in Figures 5, 6 and 7. The structure of each semiconductor device follows the traditional MOSFET structure, in which the electric field is dropped vertically across an epitaxial drift layer, with bias applied at the drain on its underside, whilst the metal-oxide-semiconductor electron channel that is formed on and extends from the substrate topside, is substantially planar.

Each of the first embodiment of the semiconductor device 10 and the second embodiment of the semiconductor device 100 comprises a gate region 30 formed on the die portion 20 and electrically connected to a gate terminal 32, a source region 40 formed in a first doped region of the main die portion 20 and electrically connected to at least one source terminal 42 and surrounded by the gate region 30, and a first drain region 50 formed in a second doped region of the main die portion 20 and electrically connected to a drain terminal 52.

In the first embodiment of the semiconductor device 10, in a top view, the source region 40 is located substantially centrally of the main die portion 20 intermediate to a main oblong portion of the gate region 30 and the first drain region 50, from which it is separated by an interstitial portion of the gate region 30. The source region 40 is electrically connected to one source terminal 42, and the gate terminal 32, the source terminal 42 and the drain terminal 52 are arranged, in a top view perspective, as a line of three terminals equidistant one from the other.

In the second embodiment of the semiconductor device 100, in a top view, the source region 40 occupies approximately one half of the main die portion 20, with a main oblong portion of the source region 40 located adjacent the gate region 30 and the first drain region 50 and an extension portion of the source region 40 extending between a main oblong portion of the gate region 30 and the first drain region 50. The source region 40 is again surrounded by the gate region 30, including adjacent the first drain region 50, i.e. the main oblong portion and extension portion of the source region 40 are separated from the first drain region 50 by an interstitial portion of the gate region 30.

In this second embodiment, the source region 40 is electrically connected to two source terminals 42a, 42b and the gate terminal 32, the source terminals 42a, 42b and the drain terminal 52 are arranged, in a top view perspective, as a matrix of two columns of two terminals. A first column comprises the drain terminal 52 and a source terminal 42a substantially aligned with each other and equidistant from one another. A second column comprises the gate terminal 32 and the second source terminal 42b substantially aligned with each other and equidistant one from the other.

The gate terminal 32, the or each source terminal 42, 42a, 42b and the drain terminal 52 are made of an electrically conducting material, for example copper, aluminium or an alloy thereof, and located atop the surface of the semiconductor substrate.

Each embodiment of the semiconductor device 10, 100 further comprises a second drain region 54 formed in a doped region of the peripheral portion 22, comprising an elongate peripheral member 56 and electrically connected to the drain terminal 52. The elongate peripheral member 56, shown with a short-dotted line in Figures 3 and 4, is a runner member made of an electrically-conducting material, for instance the same material as the gate terminal 32, the or each source terminal 42, 42a, 42b, and the drain terminal 52. Each of the second drain region 54 and the elongate peripheral member 56 accordingly surrounds the main die portion 20, inclusive of the gate region 30, the source region 40 and the first drain region 50 formed thereon.

In a top view, the second drain region 54 comprises first and second portions. The first portion of the second drain region 54 is contiguous with a majority portion of the gate region 30. In the first embodiment of the device 10, wherein the regions and their respective terminals are aligned, the first portion of the second drain region 54 corresponds to three sides of the gate region 30 distal the drain region 50. In the second embodiment of the device 100, wherein the regions and their respective terminals are not aligned, the gate terminal 32 and the drain terminal 52 are located at opposed corners of the rectangular semiconductor device 100 on a same side of the main die portion 20, i.e. wherein the first drain region 50 occupies substantially 25% of the surface of the main die portion 20, as an oblong corner section thereof. The first portion of the second drain region 54 accordingly corresponds to two full sides and a portion of each of the remaining two sides of the gate region 30 distal the drain region 50.

In a top view still, the second portion of the second drain region 54, delimited with a long-dotted line in Figures 3 and 4, is contiguous with a portion of the first drain region 50. In the first embodiment of the device 10, the second portion of the second drain region 54 corresponds to three sides of the first drain region 50 distal the gate and source regions 30, 40. In the second embodiment of the device 100, the second portion of the second drain region 54 corresponds to two orthogonal sides of the first drain region 50 distal the gate and source regions 30, 40. In both embodiments, the contiguous second portion of the second drain region 54 is effectively coplanar and integral with the first drain region 50, wherein each of the second drain region 54 and the elongate peripheral member 56 accordingly surrounds the main die portion 20 inclusive of the gate region 30, source region 40 and first drain region 50 formed thereon.

A detail of the gate region 30 of both embodiments 10, 100 is shown in cross-section in Figure 5, observing the device in Figure 3 from a left perspective and the device in Figure 4 from a top perspective, illustrating the first portion of the second drain region 54 contiguous with the gate region 30.

A detail of the gate and source regions 30, 40 of the first embodiment 10, 100 is shown in cross-section in Figure 6, observing the device in Figure 3 from a bottom perspective, and illustrating the first portion of the second drain region 54 contiguous with the gate and source regions 30, 40.

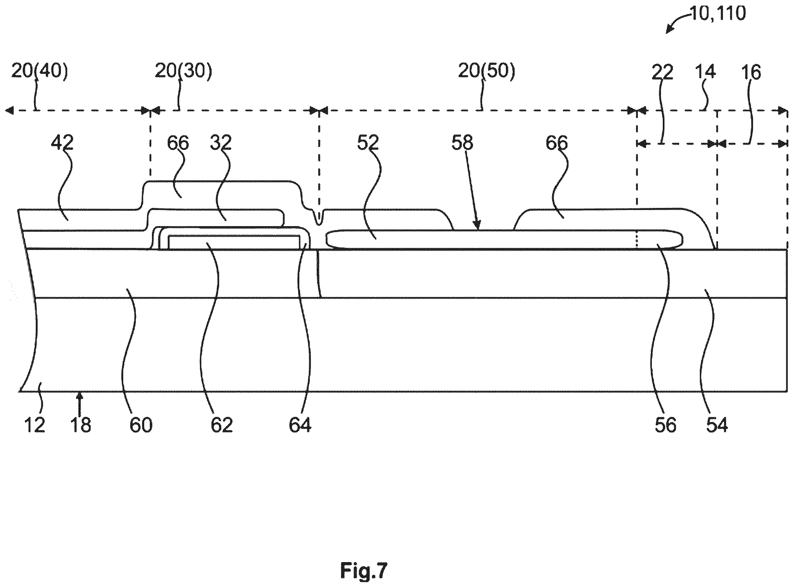

A detail of the drain region 50 of both embodiments 10, 100 is shown in cross-section in Figure 7, observing the device in either Figure 3 or Figure 4 from a right perspective, illustrating the second portion of the second drain region 54 contiguous and coplanar with the drain region 50.

With reference to Figures 5 to 7, in the embodiments described herein, the substrate of the semiconductor device 10 is used as the first and second drain regions 50, 54. The doping of the first region of the substrate 12 forms an epitaxial layer 60 as the drift region, extending through the gate region 30 and source region 40, underneath the gate terminal 32 and the or each source terminal 42. The doping of the second region of the substrate 12 forms a drain implant, extending through the drain region 50 underneath the drain terminal 52.

The doping of the second drain region 54 of the substrate 12, with a same level of ion implantation as the first region and/or as the second region, or with a distinct level of ion implantation relative to both first and second regions, forms a peripheral drain implant in order to lead current out from a back surface 18 of the substrate 12 about the entire periphery of the semiconductor device 10. In embodiments with asymmetric levels of ion implantation, a deeper level is preferred for the second drain region 54 relative to the first drain region 50.

In a cross-sectional perspective, the epitaxial layer 60 extends from the top surface of the substrate 12 by a predetermined distance in a vertical direction, up to the lateral edge of the main die portion 20 in a horizontal direction, immediately adjacent the doped layer corresponding to the second drain regions 54 which extends from the top surface of the substrate 12 by the same predetermined distance, or a different predetermined distance, in a vertical direction.

In a cross-sectional perspective still, the or each source terminal 42, the drain terminal 52 and the peripheral member 56 are formed atop the substrate top surface opposite the substrate back surface 18, whereas the gate terminal 32 is physically separated from the substrate 12 and thus the adjacent first and second drain regions 50, 54 by insulating material, for reducing the parasitic capacitance between the respective terminals. The insulating material is formed by oxidizing silicon on the surface of an epitaxial layer 60 of the substrate 12 to form an oxide layer, then depositing and growing to form polysilicon. Excess polysilicon and excess oxide layer, to be removed according to the semiconductor pattern, are etched through e.g. photolithography and etching. After etching, the oxide layer and polysilicon remaining on the surface of the epitaxial layer 60 respectively form a gate oxide layer 62 and a polysilicon layer 64 intermediate the epitaxial layer 60 and the gate terminal 32.

A passivation layer 66 is then applied to shield the top surface of the device from external contaminants, save for at least a respective portion of the top surface of each of the gate terminal 32 and the or each source terminal 42 and, as illustrated in Figure 7, a respective portion 58 of the top surface of the drain terminal 52, for electrical contact with an external circuit.

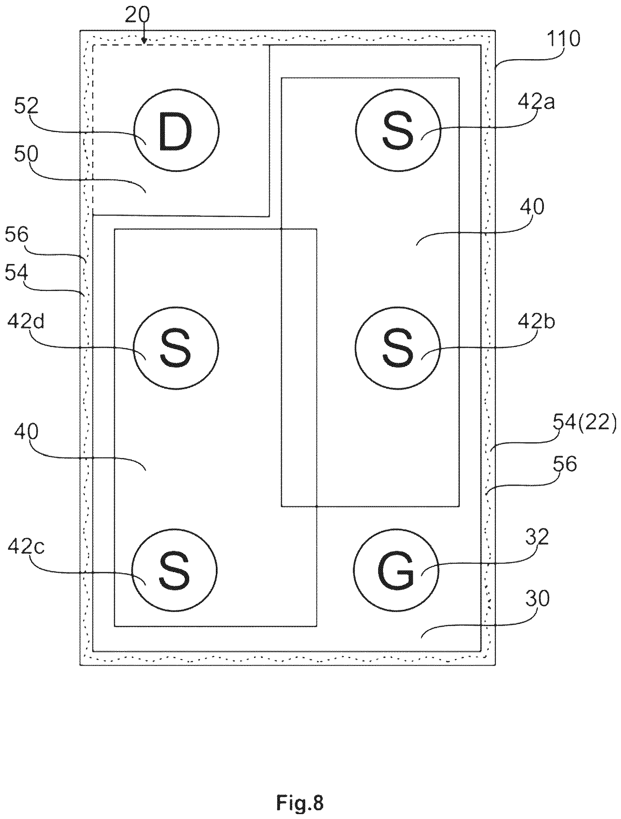

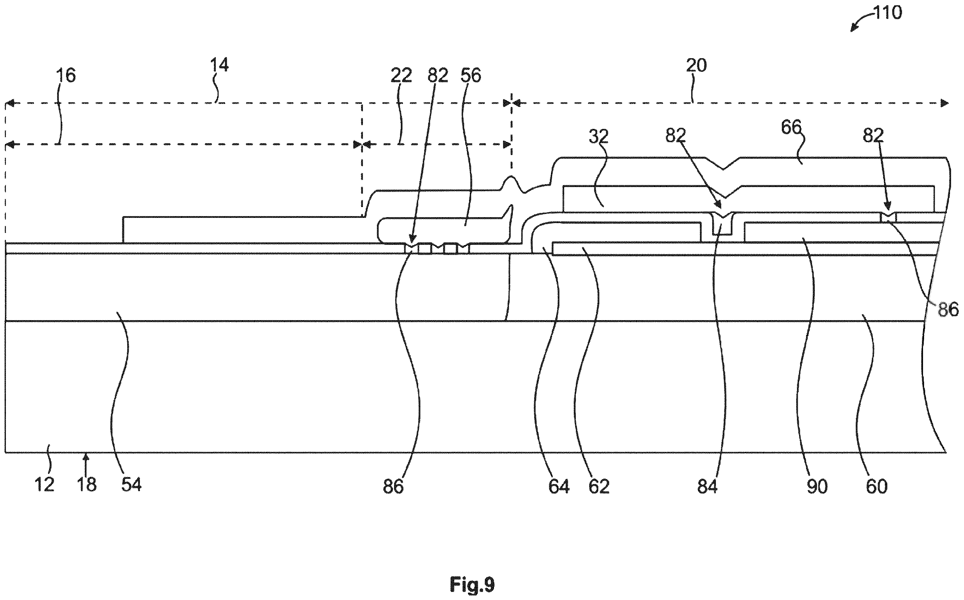

With reference to Figures 8 and 9 now, wherein like numerals correspond to like features, a further embodiment of a semiconductor device 110 is shown, the structure of which follows a CSP-packaged MOSFET structure. The semiconductor device 110 again comprises a gate region 30 formed on the die portion 20 and electrically connected to a gate terminal 32, a source region 40 formed in a first doped region of the main die portion 20 and electrically connected to, in this example, four source terminals 42a, 42b, 42c, 42d, and a first drain region 50 formed in a second doped region of the main die portion 20 and electrically connected to a drain terminal 52.

The gate terminal 32, the four source terminals 42a-42d and the drain terminal 52 are for instance made of copper or aluminium and formed on the surface of the semiconductor substrate 12 in an arrangement, in a top view perspective, of a matrix of two columns of three terminals. A first column comprises the gate terminal 32 and two source terminals 42a-42b substantially aligned with each other and equidistant one from the other. A second column comprises the drain terminal 52 and two source terminals 42c-42d substantially aligned with each other and equidistant one from the other.

In top view still, terminals of respective columns are aligned with each other and the gate terminal 32 and the drain terminal 52 are located at opposed corners of the rectangular semiconductor device 110, i.e. the gate terminal 32 is aligned with a source terminal 42c of the adjacent column distal to the drain terminal 52 and the drain terminal 52 is aligned with a source terminal 42a of the adjacent column distal to the gate terminal 32. The source region 40, located again substantially centrally of the main die portion 20, is asymmetrical according to the disposition of the four source terminals 42a-42d, yet is again surrounded by the gate region 30, adjacent the first drain region 50 which occupies substantially 16% of the surface of the main die portion 20, as an oblong corner section thereof.

The semiconductor device 110 further comprises the second drain region 54 formed in a doped region of the peripheral portion 22, comprising an elongate peripheral member 56 for instance made of copper or aluminium and electrically connected to the drain terminal 52, shown with a short-dotted line in Figure 8. In this example again, each of the second drain region 54 and the elongate peripheral member 56 accordingly surrounds the main die portion 20 inclusive of the gate region 30, source region 40 and first drain region 50 formed thereon. A first portion of the second drain region 54, delimited with a long-dotted line in Figure 5, is contiguous with a portion of the first drain region 50, in this example corresponding to two orthogonal sides of the first drain region 50 distal the gate and source regions 30, 40. A second portion of the second drain region 54 is contiguous with a portion of the gate region 30, in this example corresponding to four sides of the gate region 30 distal the drain region 50.

In a cross-sectional perspective, the gate terminal 32 is again physically separated from the first and second drain regions 50, 54 by insulating material comprising the gate oxide layer 62 and a polysilicon layer 64 intermediate the epitaxial layer 60 and the gate terminal 32. The structure of the semiconductor device 110 comprises further layers relative to the earlier example.

As a CSP packaged device, the semiconductor device 110 comprises a packaging lid 80 intermediate the metallic terminals 32, 42a-d, 52 including the metallic peripheral member 56, and lower layers of the structure, thus wherein the metallic terminals are intermediate the packaging lid 80 and the passivation layer 66.

The CSP device 110 of the third example also implements aspects of a trench MOSFET device, and accordingly includes trench arrangements to provide vertical active areas, implemented both in the main die portion 22 and in the peripheral portion 22. In the example shown in Figures 5 and 6, an underside of each metallic terminal 32, 42a-d, 52 and the metallic peripheral member 56 comprises one or more projections 82, which are substantially V-shaped in cross-section and project downwards, towards the substrate 12.

At least one projection 82 of a metallic terminal 32, 42a-d, 52 extends below the level of the terminal's underside abutting the topside of the packaging lid 80, into at least a portion of the depth of a corresponding blind trench 84. Each blind trench 84 is implemented by shaping the corresponding portion of the packaging lid 80 into a U-shape or similar, of a size complementing the terminal's projection 82.

One or more other projection(s) 82 of a metallic terminal 32, 42a-d, 52 may extend into at least a portion of the depth of a corresponding through-trench 86. Each through-trench 86 is implemented as a through hole in the corresponding portion of the packaging lid 80, of a shape and size complementing the metallic terminal's projection 82.

The or each projection 82 of the metallic peripheral member 56 extends below the level of the member's underside abutting the topside of the packaging lid 80, into at least a portion of the depth of a corresponding through-trench 86 as described above.

A further layer 90 of the structure of the semiconductor device 110 is a portion of the polysilicon layer 64 processed with an electrostatic discharge (`ESD') implantation method for improving the device's resilience to ESD events. The ESD layer 90 extends underneath the gate terminal 32 on a first side of the packaging lid blind trench 84, substantially coplanar with and adjacent the polysilicon layer 64 located on the a second side of the packaging lid blind trench 84 opposite the first. The gate oxide layer 62 extends underneath both the ESD layer 90 and the polysilicon layer 64 towards the lateral edge, but remains short of that edge to leave an interstitial space, through which an end portion of the polysilicon layer 64 is in contact with the underlying epitaxial layer 60.

Further to dicing a semiconductor device 10, 100, 110 and connecting same to an external circuit for use, when a voltage is applied to the gate terminal 32, an electric field is created in the gate oxide layer 62, which in turn creates an electric field in the semiconductor material 60. This electric field controls the flow of current through the active area 20, 22 of the semiconductor device 10.

Advantageously, the second drain region 54 in the peripheral portion 22 and the peripheral drain member 56 can reduce between 20 and 30% of static device resistivity, relative to a conventional device structure consisting solely of a die portion 20, without requiring additional silicon and without reducing the active area of the device 10, 100, 110.

In the specification the terms "comprise, comprises, comprised and comprising" or any variation thereof and the terms include, includes, included and including" or any variation thereof are considered to be totally interchangeable and they should all be afforded the widest possible interpretation and vice versa. The invention is not limited to the embodiments hereinbefore described but may be varied in both construction and detail.

## Claims

1. A semiconductor device comprising
a semiconductor substrate comprising a die portion surrounded by a peripheral portion,
a gate region formed on the die portion and connected to at least one gate terminal,
a source region formed in a first doped region of the die portion and connected to at least one source terminal,
a first drain region formed in a second doped region of the die portion and connected to at least one drain terminal, and
a second drain region formed in a doped region of the peripheral portion, comprising a peripheral member electrically connected to the or each drain terminal,
wherein the or each source terminal, gate terminal and drain terminal is formed on the surface of the semiconductor substrate and
wherein the first and second drain regions lead out from a back surface of the substrate.

2. The semiconductor device according to claim 1, wherein the peripheral portion is located in a dicing lane of a wafer comprising the semiconductor device.

3. The semiconductor device according to claim 2, wherein a dimension of the peripheral portion corresponds to a portion of the dicing lane width.

4. The semiconductor device according to any of claims 1 to 3, wherein a first portion of the second drain region is contiguous with a portion of the first drain region.

5. The semiconductor device according to claim 4, wherein a second portion of the second drain region is contiguous with a portion of the gate region.

6. The semiconductor device according to any of claims 1 to 5, wherein the peripheral portion is doped with a higher level of ion implantation relative to the die portion.

7. The semiconductor device according to any of claims 1 to 6, wherein the second drain region is doped with a higher level of ion implantation relative to the first drain region.

8. The semiconductor device according to any of claims 1 to 7, wherein the peripheral member is a metallic runner member.

9. The semiconductor device according to any of claims 1 to 8, wherein the die portion and the peripheral portion are configured with one or more vertical active areas.

10. The semiconductor device according to any of claims 1 to 9,
wherein the first doped region is connected to four source terminals ; and
wherein the gate region and the first drain region are formed on opposed corners of the die portion.

11. A Chip Size Package ('CSP') device comprising at least one semiconductor device according to any of claims 1 to 10.

12. A method of manufacturing a semiconductor device, comprising the steps of-depositing a semiconductor material on a wafer;
generating a pattern of semiconductor devices and dicing lanes with a photolithography process, wherein a mask of the photolithography process is configured to avoid masking portions of dicing lanes, such that each semiconductor device in the pattern comprises a die portion surrounded by a peripheral portion located in the dicing lane portion;
etching excess semiconductor material from the pattern, wherein the step of etching maintains semiconductor material in the form of a unitary member within each peripheral portion; and
doping each peripheral portion and at least a portion of each die portion.

13. The method according to claim 12, wherein the step of doping further comprises doping each peripheral portion differently from each die portion.

14. The method according to claim 13, wherein the step of doping further comprises doping each peripheral portion with a higher level of ion implantation relative to each die portion.

15. The method according to any of claims 12 to 14, wherein the maintained unitary member is a metallic runner member.
